# EUROPÄISCHE PATENTSCHRIFT

(11) **EP 2 822 128 B1**
(45) Veröffentlichungstag und Bekanntmachung des Hinweises auf die Patenterteilung: **04.04.2018**
(21) Anmeldenummer: 14175395.4
(22) Anmeldetag: 02.07.2014
(51) Int. Cl.: H02H 5/10, G01R 31/04

(54) **Vorrichtung und Verfahren zum Erkennen eines Neutralleiterbruches**
Device and method for detecting a neutral wire break
Dispositif et procédé de reconnaissance d'une coupure de conducteur neutre

(30) Priorität: 05.07.2013 DE 102013011235; 09.10.2013 DE 102013016710
(43) Veröffentlichungstag der Anmeldung: 07.01.2015
(73) Patentinhaber: ABB AG, 68309 Mannheim (DE)
(72) Erfinder: Liebhardt, Christian, 68535 Edingen-Neckarhausen (DE); Zowislok, Florian, 77933 Lahr (DE)

(56) Entgegenhaltungen:
- EP-A2- 1 353 428
- DE-A1- 4 339 241
- DE-A1-102007 046 921
- FR-A1- 2 549 287
- GB-A- 2 117 196

## Beschreibung

Die Erfindung betrifft eine Vorrichtung zum Erkennen eines Neutralleiterbruches in der Zuleitung zu einem an einem Drehstromnetz mit Phasenleitern und einem Neutralleiter betriebenen Gerät, ausgehend vom Oberbegriff des Anspruchs 1.

Die Erfindung betrifft auch ein Verfahren zum Erkennen eines Neutralleiterbruches in der Zuleitung zu einem an einem Drehstromnetz mit Phasenleitern und einem Neutralleiter betriebenen Gerät, ausgehend vom Oberbegriff des Anspruchs 10.

Die Erfindung betrifft weiter eine Anordnung zum Erkennen eines Neutralleiterbruches in der Zuleitung zu einem an einem Drehstromnetz mit Phasenleitern und einem Neutralleiter betriebenen Gerät, ausgehend vom Oberbegriff des Anspruchs 11.

Beim Betrieb von elektrischen Geräten, beispielsweise Messgeräten, an einem Drehstromnetz mit Neutralleiter, einem sogenannten 3 Phasen + N - Netz, ist eine Neutralleiterüberwachung in der Zuleitung zudem Gerät erforderlich. Es soll dabei erkannt werden, ob oder wenn der Neutralleiter unterbrochen ist. Ein Unterbrechen des Neutralleiters kann in Folge eines Bruchs des Neutralleiters auftreten, oder der Neutralleiter kann aus der Klemme rutschen.

Bei bisher bekannten Vorrichtungen zum Erkennen eines Neutralleiterbruches in einem an einem Drehstromnetz betriebenen Gerät wird anhand der Verschiebung eines intern künstlich erzeugten Sternpunktes und der daraus resultierenden Asymmetrie der drei Phasen auf eine Unterbrechung des Neutralleiters geschlossen. Ein intakter Neutralleiter hält den Sternpunkt in der Mitte. Bei Unterbrechung des Neutralleiters entsteht eine bleibende Asymmetrie.

Allerdings kann eine Asymmetrie auch andere Ursachen haben, beispielsweise den Ausfall einer Phase, oder einen Schaden oder ein unvorhergesehenes Lastverhalten an einem anderen angeschlossenen Gerät, beispielsweise einem Elektromotor, bei ansonsten intaktem Neutralleiter.

Bei bisher bekannten Vorrichtungen und Verfahren zum Erkennen eines Neutralleiterbruches besteht somit die Gefahr, dass ein Neutralleiterbruch nicht oder fälschlich erkannt wird, wenn im Drehstromnetz Asymmetrien auftreten. Eine Unterbrechung des Neutralleiters kann bisher nicht sicher von einer auf andere Weise hervorgerufenen Asymmetrie unterschieden werden.

Ein weiterer Nachteil bekannter Vorrichtungen und Verfahren ist, dass damit bei fehlendem Neutralleiter eine korrekte Messung der Außenleiterspannungen, von Phase zu Phase, nur noch mit einer differenziellen Messung durchgeführt werden kann.

Die DE 43 39 241 A1 zeigt eine Schaltungsanordnung zur Überwachung und Erkennung eines Ausfalls des Nullleiters oder eines Phasenleiters eines Drehstromnetzes, bei der die Phasenleiter über Widerstände zu einem Sternpunkt zusammengeschaltet sind, der wiederum über einen Widerstand an die mit dem Nullleiter in Verbindung stehenden Masse der Schaltungsanordnung angeschlossen ist, wobei über zwei Phasenleiter die Spannungsversorgung der Schaltung abgeleitet wird, während der dritte Phasenleiter mit einer Messschaltung zur Erfassung des Fließens eines Stromes verbunden ist, und wobei die Messschaltung mit einer Vergleichsschaltung in Verbindung steht, wobei die Vergleichsschaltung sowohl das Fließen bzw. Nichtfließen des Stroms in der Messschaltung feststellt, als auch das Fließen eines Stroms zwischen Sternpunkt und Masse erfasst, wobei ein Ausfallsignal von der Vergleichsschaltung geliefert wird, wenn kein Strom durch die Messschaltung fließt und wenn ein Strom zwischen Sternpunkt und Masse fließt.

Die EP1 353 428 A2 zeigt eine Leiterunterbrechungs- Schutzschaltung mit: einer Auslösespule zum Auslösen eines elektrischen Kontaktes, in Abhängigkeit eines durch die Auslösespule hindurchfließenden Halte-Spulenstromes; und einer Überspannungsschutzeinrichtung zum Schützen der dazu parallelliegenden Auslösespule vor Überspannungen und / oder Überströmen; wobei der bei einer Unterbrechung eines Leiters abfallende Halte-Spulenstrom über die Auslösespule einen Schutzschalter auslöst.

Die GB 2 117 196 A zeigt eine Schaltung zum Überwachen des Phasenausfalls in einer mehrphasigen Stromversorgung, mit einem Relais, das durch einen der Phasenleiter versorgt wird, und mit einer Halbleiter-Schaltungsanordnung, um das Relais bei Auftreten eines Fehlers in der Spannungsversorgung kurzzuschließen, wobei drei Phasenleiter über Widerstände zu einem Sternpunkt verbunden sind, der bei intakten Phasenleitern zu Null-Potential ausbalanciert ist, wobei bei Ausfall einer oder mehrerer Phasen der Sternpunkt nicht mehr ausbalaciert ist, wodurch ein Schalttransistor leitend wird und über den Schalttransistor die Relaisspule kurzgeschlossen wird.

Es ist daher die Aufgabe der vorliegenden Erfindung, eine Vorrichtung zum Erkennen eines Neutralleiterbruches in der Zuleitung zu einem an einem Drehstromnetz betriebenen Gerät zu schaffen, wobei eine Erkennung einer Unterbrechung des Neutralleiters eindeutig erfolgt, unbeeinflusst von auf sonstige Weise möglicherweise auftretendes Asymmetrien.

Es ist eine weitere Aufgabe der vorliegenden Erfindung, ein verbessertes Verfahrens zum Erkennen eines Neutralleiterbruches zu schaffen.

Es ist eine weitere Aufgabe der vorliegenden Erfindung, eine Anordnung zum Erkennen eines Neutralleiterbruches zu schaffen, die eine sichere Erkennung einer Unterbrechung des Neutralleiters und eine Netztrennung im erkannten Fehlerfall ermöglicht.

Die Aufgabe wird bezüglich der Vorrichtung erfindungsgemäß gelöst durch eine Vorrichtung mit den Merkmalen des Anspruchs 1.

Bezüglich des Verfahrens zum Erkennen eines Neutralleiterbruches wird die Aufgabe gelöst durch ein Verfahren mit den Merkmalen des Anspruchs 10.

Bezüglich der Anordnung zum Erkennen eines Neutralleiterbruches wird die Aufgabe gelöst durcheine Anordnung mit den Merkmalen des Anspruchs 11.

Erfindungsgemäß also ist in der Vorrichtung ein virtueller Sternpunkt durch Zusammenschalten der Phasenleiter und des Neutralleiters über Spannungsteiler gebildet, wobei die Vorrichtung eine Messvorrichtung mit einem Messeingang hat zur Erfassung wenigstens des Messsignalverlaufs des Neutralleiters am Mittelabgriff des dem Neutralleiter zugeordneten Spannungsteilers, wobei die Vorrichtung eine resistive und gleichrichtende Eigenschaften aufweisende Abbildungsschaltung hat, die in der Vorrichtung zwischen die drei Phasen (L1, L2, L3) und den Neutralleiter (N) geschaltet ist, wodurch bei Unterbrechung des Neutralleiters (N) das Messsignal des Neutralleiters bezogen auf den virtuellen Sternpunkt mit einem Gleichanteil beaufschlagt wird. Gemäß einer vorteilhaften Ausführungsform der Erfindung bildet die Abbildungsschaltung bei Unterbrechchung des Neutralleiters die Einhüllende von einer, von zwei oder der drei Phasen auf den Messeingang des Neutralleiters ab. Die positive oder, bei pull-down, die negative Einhüllende kann dazu verwendet werden.

Gemäß einer vorteilhaften Ausführungsform kann alternativ zu der Einhüllenden auch eine positive bzw. negative DC - Spannung eingesetzt werden.

Gemäß einer vorteilhaften Ausführungsform der Erfindung sind die die Spannungsteiler dabei identische Spannungsteiler.

Die erfindungsgemäße Vorrichtung umfasst also eine Schaltung, bestehend aus vier Spannungsteilern an jeweils den Phasen L1, L2, L3 und am Neutralleiter N, die einen virtuellen Sternpunkt bilden. Die einzelnen Phasen können am Mittelabgriff des jeweiligen Spannungsteilers erfasst werden. Ein zusätzliches Schaltungselement mit resistiver und gleichrichtender Eigenschaft wird intern zwischen die drei Phasen und den Neutralleiter geschaltet. Wenn der Neutralleiter gebrochen bzw. nicht angeschlossen ist, bildet dieses Element die positive oder negative Einhüllende der drei Phasen auf den Messeingang des Neutralleiters ab. Dadurch wird das Messsignal des Neutralleiters bezogen auf den virtuellen Sternpunkt mit einem Gleichanteil beaufschlagt. Eine Unterbrechung des Neutralleiters kann daher an einem Auftreten eines Gleichanteils im Messsignal des Neutralleiters sicher erkannt werden kann. Die Messung der Außenleiterspannungen wird dadurch nicht beeinflusst.

In der erfindungsgemäßen Vorrichtung gelingt es, bei einer Unterbrechung des Neutralleiters in der Messeinrichtung einen Zustand herzustellen, der bei einem Phasenausfall oder einer anderweitig erzeugten Phasenasymmetrie nicht auftreten würde. Dadurch wird eine Unterbrechung des Neutralleiters eindeutig und zweifelsfrei erkennbar.

Gemäß einer vorteilhaften Ausführungsform der Erfindung umfasst die Vorrichtung eine Gleichanteil-Erkennungsvorrichtung für das von der Messvorrichtung am Messeingang erfasste Messsignal des Neutralleiters, die bei Erkennen eines Gleichanteils des Messsignals des Neutralleiters ein Steuersignal erzeugt, wobei das Steuersignal ein Fehlen oder eine Unterbrechung des Neutralleiters anzeigt.

Gemäß einer vorteilhaften Ausführungsform der Erfindung umfasst die Abbildungsschaltung für jede Phase ein gleichrichtendes Element, wobei der Eingang jedes gleichrichtenden Elementes mit der diesem Element zugeordneten Phasenleitung verbunden ist, wobei die Ausgänge der gleichrichtenden Elemente in einem Verbindungspunkt zusammengeschaltet sind, und wobei die Abbildungsschaltung ein resistives Element umfasst, das den Verbindungspunkt der gleichrichtenden Elemente mit dem Eingang des dem Neutralleiter zugeordneten Spannungsteilers verbindet. Die erfindungsgemäß vorteilhafte Funktion ist die folgende. Wenn der Neutralleiter intakt ist, dann oszilliert das Signal des Neutralleiters um Null, der Mittelwert des Signals des Neutralleiters bei ungestörtem Neutralleiter ist Null. Bei Auftreten einer Unterbrechung des Neutralleiters zieht das resistive Element das Potential an dem Verbindungspunkt nach oben. Dadurch oszilliert jetzt das Signal des Neutralleiters um einen positiven Wert. Der Mittelwert des Signals des Neutralleiters bei unterbrochenem Neutralleiter ist nicht mehr Null, sondern dieser verschobene Wert. Die Gleichanteil-Erkennungsvorrichtung erkennt das Vorliegen eines verschobenen Mittelwerts des Signals des Neutralleiters. Wegen der erfindungsgemäßen Gestaltung der Abbildungsschaltung kann ein solcher verschobener Mittelwert nur bei einer Unterbrechung des Neutralleiters auftreten..

Gemäß einer vorteilhaften Ausführungsform der Erfindung umfasst die Messvorrichtung einen Mikrocontroller, der die Messsignal-Erfassung und Messsignal-Verarbeitung durchführt, wobei die Stromversorgung des Mikrocontrollers galvanisch getrennt ist von dem Drehstrom-Netz. Dies ist wichtig, damit sich der virtuelle Sternpunkt zwischen den Phasen einstellen kann. Eine galvanische Trennung des Mikrocontrollers kann beispielsweise durch ein separates Netzteil zur Versorgung des Mikrocontrollers realisiert werden. Das Netzteil kann ein galvanisch getrenntes Schaltnetzteil sein. Es kann Bestandteil der Vorrichtung zur Überwachung eines Drehstromnetzes sein. In diesem Fall hat die erfindungsgemäße Vorrichtung keine getrennte Stromversorgung, sie versorgt sich direkt aus dem zu überwachenden Drehstromnetz. Das erfindungsgemäße Überwachungsprinzip funktioniert selbstverständlich auch, wenn eine separate Stromversorgung für die erfindungsgemäße Vorrichtung vorhanden ist, die dann als ein separates Netzteil ausgeführt sein kann.

Gemäß einer vorteilhaften Ausführungsform der Erfindung hat jeder Spannungsteiler einen ersten, hohen Spannungsteiler-Widerstand zur Begrenzung des Stroms, der in die Messvorrichtung fließt, und einen zweiten, niedrigen Spannungsteiler-widerstand zur Anpassung der Netzspannung an das erlaubte Eingangsspannungs-Niveau der Messvorrichtung.

Die Erkennung eines Gleichanteils im Messsignal des Neutralleiters kann auch ohne Mikrocontroller erfolgen. Gemäß einer vorteilhaften Ausführungsform der Erfindung umfasst die Messvorrichtung eine analoge elektronische Integrator-Schaltung zur Erkennung des Gleichanteils im Mittelwert des Messsignals des Neutralleiters.

Ein erfindungsgemäßes Verfahren zum Erkennen eines Neutralleiterbruches in einem Drehstromnetz, mit Phasenleitern und einem Neutralleiter, umfasst die Schritte
- Bilden eines virtuellen Sternpunkts durch Zusammenschalten der Phasenleiter und des Neutralleiters über Spannungsteiler, insbesondere identische Spannungsteiler,
- Erfassen des Messsignalverlaufs des Neutralleiters am Mittelabgriff des dem Neutralleiter (N) zugeordneten Spannungsteilers,
- Erkennen eines Gleichanteils im Mittelwert des Messsignals des Neutralleiters,
- Erzeugen eines Steuersignals bei Erkennen eines Gleichanteils des Messsignals des Neutralleiters, wobei das Steuersignal ein Fehlen oder eine Unterbrechung des Neutralleiters anzeigt.

Eine erfindungsgemäße Anordnung zum Erkennen eines Neutralleiterbruches in einem Drehstromnetz, mit Phasenleitern und einem Neutralleiter, umfasst
- eine Vorrichtung zum Erkennen eines Neutralleiterbruches, wie oben beschrieben, und
- einen Schaltmechanismus zum Unterbrechen der Phasenleiter, wobei das Steuersignal der Vorrichtung den Schaltmechanismus derart steuert, dass die Phasenleiter unterbrochen werden, wenn ein Gleichanteil im Messsignal des Neutralleiters erkannt worden ist. Bei dem Schaltmechanismus kann es sich in vorteilhafter Ausgestaltung um ein Relais handeln.

Eine erfindungsgemäße Vorrichtung zum Erkennen eines Neutralleiterbruches kann beispielsweise in einer Anordnung zu Netzeinspeiseüberwachung verwendet werden. Am Netzeinspeisepunkt von dezentralen Energieerzeugern, beispielsweise von Photovoltaikanlagen, ins Stromnetz soll durch Überwachung, beispielsweise mit einem Messgerät, sichergestellt werden, dass die einzuspeisende Spannung sauber ist, das heißt, dass keine Asymmetrie vorliegt. Das Messgerät wird eingangsseitig mit den Phasen und dem Neutralleiter des Drehstromnetzes verbunden. Wenn der Neutralleiter auf dem Weg zum Messgerät hin unterbrochen ist, kommt es zu fehlerhaften Messungen. Eine Netzeinspeiseüberwachung ist dann nicht mehr zuverlässig möglich. Daher soll ein Neutralleiterbruch am Messgeräteeingang erkannt werden können. Dazu wird das Messgerät mit einer erfindungsgemäßen Vorrichtung zum Erkennen eines Neutralleiterbruches versehen. Die erfindungsgemäße Vorrichtung verhindert falsche Messungen aufgrund eines gebrochenen Neutralleiters.

Wenn eine Unterbrechung des Neutralleiters erkannt wird, kann der in der erfindungsgemäßen Anordnung vorgesehene Schaltmechanismus den Wechselrichter der Photovoltaikanlage vom Einspeisenetz trennen, um zu verhindern, dass wegen einer fehlerhaften Messung die Qualität der eingespeisten Spannung nicht mehr richtig überwacht werden kann und um somit die Gefahr des Einspeisens von "unsauberer" Spannung zu unterbinden.

Die vorliegende Erfindung ermöglicht erstmals eine sichere Erkennung eines Bruchs des Neutralleiters in einem Drehstromnetz bei jeglichen Betriebsbedingungen. Weiterhin können mit der erfindungsgemäßen Vorrichtung die Außenleiterspannungen, von Phase zu Phase, ohne zusätzlichen Hardwareaufwand in allen Betriebszuständen, auch bei unterbrochenem Neutralleiter, gemessen werden.

Die Erfindung sowie weitere vorteilhafte Ausgestaltungen und Verbesserungen der Erfindung soll im Folgenden auch unter Bezug auf die beigefügten Zeichnungen und Diagramme näher erläutert und beschrieben werden.

Es zeigen:
- Figur 1:: schematisch ein Blockschaltbild einer erfindungsgemäßen Vorrichtung zur Überwachung des Neutralleiters,
- Figur 2:: schematisch ein Blockschaltbild einer erfindungsgemäßen Anordnung zur Überwachung eines Drehstromnetzes,
- Figur 3:: den Signalverlauf der Spannungssignale zwischen den Phasen und dem Neutralleiter sowie des Signals des Neutralleiters bei ungestörtem Neutralleiter, sowie
- Figur 4:: den Signalverlauf der Spannungssignale zwischen den Phasen untereinander sowie des Signals des Neutralleiters bei unterbrochenem Neutralleiter.

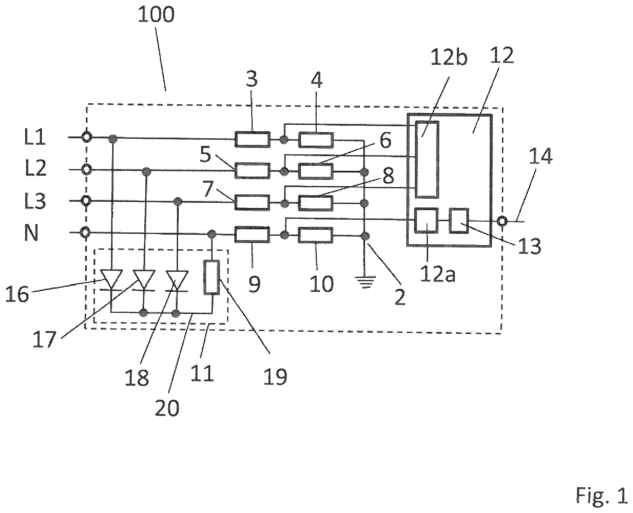

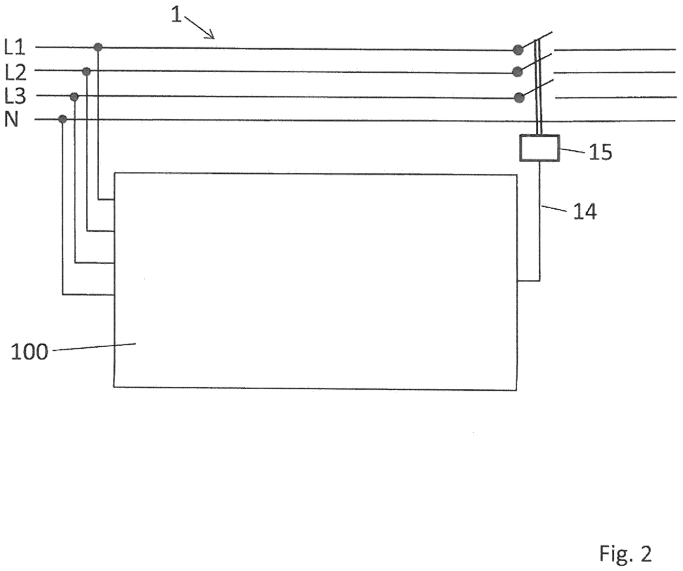

Figur 1 zeigt schematisch ein Blockschaltbild einer erfindungsgemäßen Vorrichtung zum Erkennen eines Neutralleiterbruches.in der Zuleitung zu einem an einem Drehstromnetz betriebenen Gerät 100. Die Vorrichtung ist als elektronische Schaltung aufgebaut und in dem Gerätegehäuse eingebaut. An einer, hier der linken, Seite befinden sich Anschlussvorrichtungen, beispielsweise Anschlussklemmen, zum Anschließen der Phasenleiter L1, L2, L3 und des Neutralleiters N des Drehstromnetzes 1, welches in Figur 2 schematisch dargestellt ist.

Von der Anschlussklemme aus verläuft der Strompfad innerhalb der Vorrichtung von jeder Phase L1, L2, L3 und dem Neutralleiter N zu einem Spannungsteiler. Der der Phase L1 zugeordnete Spannungsteiler ist mit den Widerständen 3, 4 gebildet. Der der Phase L2 zugeordnete Spannungsteiler ist mit den Widerständen 5, 6 gebildet. Der der Phase L3 zugeordnete Spannungsteiler ist mit den Widerständen 7,8 gebildet. Der dem Neutralleiter N zugeordnete Spannungsteiler ist mit den Widerständen 9, 10 gebildet. Die den einzelnen Phasen und dem Neutralleiter zugeordneten Spannungsteiler sind hier identisch aufgebaut. Die Widerstände 3, 5, 7, 9 haben hier jeweils den gleichen Wert. Sie sind hochohmig. Die Widerstände 4, 6, 8, 10 habe jeweils auch denselben Wert. Sie sind niederohmig.

Die Vorrichtung hat eine Messvorrichtung 12 mit einem Messeingang. Der Mittelabgriff jedes der Spannungsteiler ist mit dem Messeingang der Messvorrichtung 12 verbunden. Die Messvorrichtung misst, erfasst und verarbeitet die Signale der Phasenspannungen L1, L2, L3 und des Neutralleiters N. Die Messvorrichtung 12 hat einen Funktionsblock 12b zur Messung, Erfassung und Verarbeitung der Signale der Phasen L1, L2,L3, und einen Funktionsblock 12a zur Messung, Erfassung und Verarbeitung des Signals des Neutralleiters N. Beide Funktionsblöcke arbeiten zusammen. Die Messvorrichtung 12 misst, erfasst, stellt dar und verarbeitet insbesondere die Signale der Spannungen zwischen den Phasen und dem Neutralleiter, also die Signale L1-N, L2-N, L3-N , sowie die Spannungen zwischen den Phasenleitern selbst, also L1-L2, L2-L3, L1-L3.

Das Gerät 100 mit der Messvorrichtung 12 kann damit als ein Gerät zur Überwachung der Netzqualität des Drehstromnetzes 1, siehe Figur 2, betrachtet werden.

Die Messvorrichtung 12 kann einen Mikrocontroller umfassen, der die Messsignal-Erfassung und Messsignal-Verarbeitung durchführt. In diesem Fall ist die Stromversorgung des Mikrocontrollers (nicht in der Figur dargestellt) galvanisch getrennt von dem Drehstrom-Netz. Dies ist wichtig, damit sich der virtuelle Sternpunkt 2 zwischen den Phasen einstellen kann. Eine galvanische Trennung des Mikrocontrollers kann beispielsweise durch ein separates Netzteil (nicht in den Figuren dargestellt) zur Versorgung des Mikrocontrollers realisiert werden. Das Netzteil kann dabei ein galvanisch getrenntes Schaltnetzteil sein. Es kann Bestandteil der Vorrichtung zum Erkennen eines Neutralleiterbruches sein. In diesem Fall hat die erfindungsgemäße Vorrichtung keine getrennte Stromversorgung, sie versorgt sich direkt aus dem zu überwachenden Drehstromnetz. Das erfindungsgemäße Überwachungsprinzip funktioniert selbstverständlich auch, wenn eine separate Stromversorgung für die erfindungsgemäße Vorrichtung vorhanden ist, die dann als ein separates Netzteil ausgeführt sein kann.

Jeder Spannungsteiler hat also einen ersten, hohen Spannungsteiler-Widerstand zur Begrenzung des Stroms, der in die Messvorrichtung 12 fließt, und einen zweiten, niedrigen Spannungsteiler-Widerstand zur Anpassung der Netzspannung an das erlaubte Eingangsspannungs-Niveau der Messvorrichtung 12. Der erste, hohe Spannungsteiler-Widerstand kann beispielsweise 1MΩ betragen, der der zweite, niedrige Spannungsteiler-Widerstand kann beispielsweise 3kΩ betragen.

Es soll angemerkt werden, dass die Erfindung nicht auf die hier beschriebene Ausführung mit der erwähnten Wertigkeit der Widerstände beschränkt ist. Die erfindungsgemäße Vorrichtung kann auch in einem Niederspannungsdrehstromnetz verwendet werden, Dann können die Widerstände 3, 5, 7, 9 auch beispielsweise niederohmig sein.

Die Ausgänge der Spannungsteiler sind elektrisch miteinander verbunden. Somit ist in der Vorrichtung durch Zusammenschalten der Phasenleiter L1, L2, L3 und des Neutralleiters N über die identischen Spannungsteiler ein virtueller Sternpunkt 2 gebildet.

Weiter hat die Vorrichtung eine resistive und gleichrichtende Eigenschaften aufweisende Abbildungsschaltung 11. Diese ist in der Vorrichtung zwischen die drei Phasen L1, L2, L3 und den Neutralleiter N geschaltet. Die Abbildungsschaltung 11 hat für jede Phase L1, L2, L3 ein gleichrichtendes Element, hier eine Diode, 16, 17, 18. Die Dioden 16, 17, 18 sind in Durchgangsrichtung zwischen dem jeweiligen Phasenleiter L1, L2,L3 und dem Neutralleiter N geschaltet. Der Eingang jeder der Dioden 16, 17, 18 ist mit der dieser Diode zugeordneten Phasenleitung L1, L2, L3 verbunden. Die Ausgänge der Dioden 16, 17, 18 sind in einem Verbindungspunkt 20 zusammengeschaltet. Der Verbindungspunkt 20 ist mit dem Eingang des dem Neutralleiter N zugeordneten Spannungsteilers mittels eines Widerstandes 19 verbunden. Dieser muss hochohmig sein. Bevorzugt liegt sein Wert in derselben Größenordnung wie der Wert der ersten, hohen Widerstände 3, 5, 7, 9 der Spannungsteiler. Er kann beispielsweise denselben Widerstandswert haben wie diese, also beispielsweise auch 1MΩ.

Die erfindungsgemäß vorteilhafte Funktion ist die folgende. Wenn der Neutralleiter N in der Zuführung zu der Vorrichtung 100 intakt ist, dann oszilliert das Signal des Neutralleiters N um Null, der Mittelwert des Signals des Neutralleiters N bei ungestörtem Neutralleiter ist Null. Bei Auftreten einer Unterbrechung des Neutralleiters N in der Zuführung zu der Vorrichtung 100 zieht das resistive Element 19 das Potential an dem Verbindungspunkt 20 nach oben. Dadurch oszilliert jetzt das Signal des Neutralleiters N um einen positiven Wert. Der Mittelwert des Signals des Neutralleiters bei unterbrochenem Neutralleiter ist nicht mehr Null, sondern dieser positive Wert.

Dadurch bildet sich bei Unterbrechung des Neutralleiters N die Einhüllende der drei Phasen L1, L2, L3 auf den Messeingang des Neutralleiters N ab. Dadurch wird das Messsignal des Neutralleiters N bezogen auf den virtuellen Sternpunkt 2 mit einem Gleichanteil beaufschlagt. Eine Unterbrechung des Neutralleiters N kann an einem Auftreten eines Gleichanteils im Messsignal des Neutralleiters N sicher erkannt werden. Die Messung der Außenleiterspannungen wird dadurch nicht beeinflusst.

Gemäß einer vorteilhaften Ausführungsform der Erfindung umfasst die Messvorrichtung 12 eine Gleichanteil-Erkennungsvorrichtung 13 für das von der Messvorrichtung 12a am Messeingang erfasste Messsignal des Neutralleiters, die bei Erkennen eines Gleichanteils des Messsignals des Neutralleiters ein Steuersignal 14 erzeugt, wobei das Steuersignal 14 ein Fehlen oder eine Unterbrechung des Neutralleiters N anzeigt. Wenn die Messvorrichtung 12 einen Mikrocontroller umfasst, kann die Gleichanteil-Erkennungsvorrichtung als ein Algorithmus oder ein Funktionsblock im Anwendungsprogramm des Mikrocontrollers ausgebildet sein.

Die Gleichanteil-Erkennungsvorrichtung 13 erkennt das Vorliegen eines positiven Mittelwerts des Signals des Neutralleiters N. Wegen der erfindungsgemäßen Gestaltung der Abbildungsschaltung 11 kann ein solcher positiver Mittelwert nur bei einer Unterbrechung des Neutralleiters auftreten. In der erfindungsgemäßen Vorrichtung 100 gelingt es daher, bei einer Unterbrechung des Neutralleiters N in der Messeinrichtung 12 einen Zustand herzustellen, der bei einem Phasenausfall oder einer anderweitig erzeugten Phasenasymmetrie nicht auftreten würde. Dadurch wird eine Unterbrechung des Neutralleiters N eindeutig und zweifelsfrei erkennbar.

Die Erkennung eines Gleichanteils im Messsignal des Neutralleiters kann auch ohne Mikrocontroller erfolgen. Dann umfasst die Messvorrichtung 12 eine analoge elektronisehe Integrator-Schaltung zur Erkennung des Gleichanteils im Mittelwert des Messsignals des Neutralleiters.

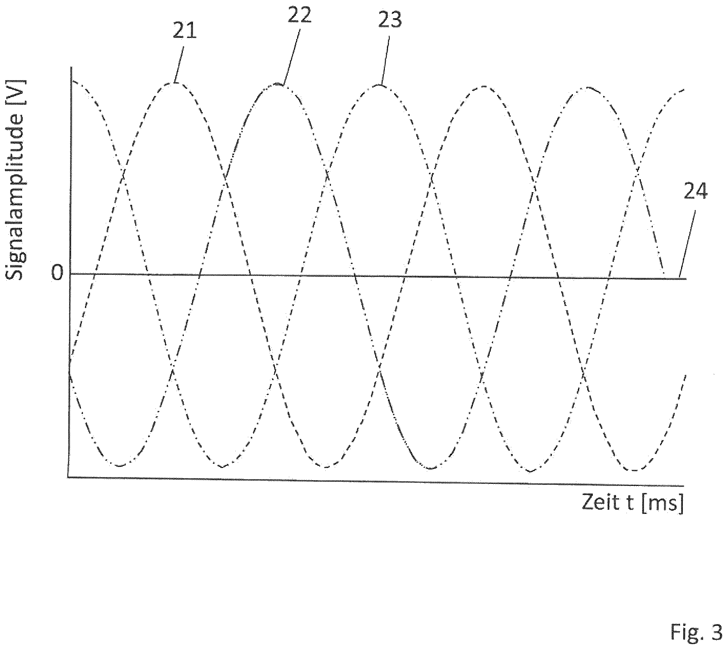

Die Figur 3 zeigt für den Fall des ungestörten Neutralleiters, ungestört außerhalb der Vorrichtung 100, den zeitlichen Verlauf der intern in der Messvorrichtung 12 erfassten internen Spannungssignale für die Differenzspannung zwischen jeder Phase und dem Neutralleiter, gewissermaßen der Sternspannungen. Die Bezugsziffer 21 bezeichnet die interne Spannung zwischen L1 und N. Die Bezugsziffer 22 bezeichnet die interne Spannung zwischen L2 und N. Die Bezugsziffer 23 bezeichnet die interne Spannung zwischen L3 und N. Die Spannungen haben einen normalen sinusförmigen Verlauf. Die Bezugsziffer 24 bezeichnet das interne Signal des Neutralleiters N, innerhalb der Vorrichtung 100 erfasst von der Messvorrichtung 12. Bei außerhalb ungestörtem Neutralleiter und symmetrischem Netz ist dieses interne Signal Null.

Wenn bei ungestörtem äußeren Neutralleiter eine Phasenasymmetrie im Netz auftritt, beispielsweise durch Ausfall einer Phase, dann würde das interne Signal 24 des Neutralleiters oszillieren, aber um den Mittelwert Null. Wenn eine Phasenverschiebung im Netz auftritt, würde das interne Signal 24 stärker oszillieren, aber immer noch um den Mittelwert Null.

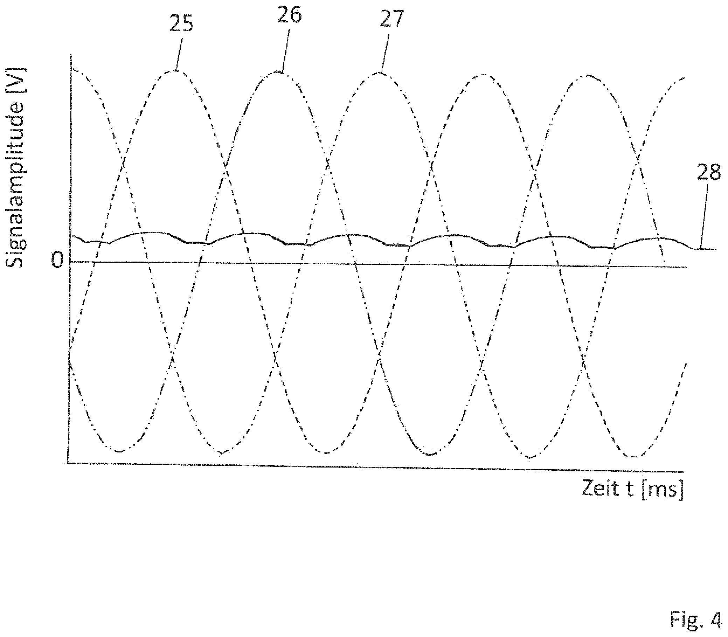

Wenn der Neutralleiter außerhalb des Gerätes 100 unterbrochen ist, dann oszilliert das interne Signal des Neutralleiters, erfasst innerhalb der Vorrichtung mit der Messvorrichtung 12, nicht mehr sinusförmig, und auch nicht mehr um den Mittelwert Null. Die Figur 4 zeigt diese Situation bei außerhalb des Gerätes 100 unterbrochenem Neutralleiter anhand der zeitlichen Verläufe der internen Signalverläufe der intern der Vorrichtung in der Messvorrichtung 12 erfassten Spannungssignale für die Differenzspannung zwischen jeweils zwei Phasen, gewissermaßen der Dreiecksspannungen. Die Bezugsziffer 25 bezeichnet die interne Spannung zwischen L1 und L2. Die Bezugsziffer 26 bezeichnet die interne Spannung zwischen L2 und L3. Die Bezugsziffer 27 bezeichnet die interne Spannung zwischen L3 und L1. Diese Dreiecksspannungen haben immer noch einen normalen sinusförmigen Verlauf. Die Bezugsziffer 28 bezeichnet das interne Signal des Neutralleiters N, intern erfasst durch die Messvorrichtung 12. Der Neutralleiter ist hier außerhalb der Vorrichtung 100 unterbrochen. Man erkennt, dass das interne Signal des Neutralleiters jetzt keinen sinusförmigen Verlauf mehr hat, und der Mittelwert ist positiv, deutlich von Null verschieden. Dies ist das hinreichende und notwendige Indiz für das Vorliegen einer Unterbrechung des Neutralleiters außerhalb des Gerätes 100.

Die Figur 2 zeigt eine erfindungsgemäße Anordnung zum Erkennen eines Neutralleiterbruches in einem Drehstromnetz 1, mit Phasenleitern L1, L2, L3 und einem Neutralleiter N. Die Anordnung gemäß Figur 2 umfasst ein Gerät 100 mit einer Vorrichtung zum Erkennen eines Neutralleiterbruches, wie oben beschrieben, und einen Schaltmechanismus 15 zum Unterbrechen der Phasenleiter L1, L2, L3. Das Steuersignal 14 der Vorrichtung 100 steuert den Schaltmechanismus 15 derart, dass die Phasenleiter L1, L2, L3 unterbrochen werden, wenn ein Gleichanteil im internen Messsignal des Neutralleiters N erkannt worden ist. Bei dem Schaltmechanismus 15 handelt es sich hier um ein Relais.

Die Anordnung nach Figur 2 kann beispielsweise in einer Anordnung zu Netzeinspeiseüberwachung verwendet werden. Am Netzeinspeisepunkt von dezentralen Energieerzeugern, beispielsweise von Photovoltaikanlagen, ins Stromnetz soll durch Überwachung, beispielsweise mit einem Messgerät, sichergestellt werden, dass die einzuspeisende Spannung sauber ist, das heißt, dass keine Asymmetrie vorliegt. Das Messgerät wird eingangsseitig mit den Phasen und dem Neutralleiter des Drehstromnetzes verbunden. Wenn der Neutralleiter auf dem Weg zum Messgerät hin unterbrochen ist, kommt es zu fehlerhaften Messungen. Eine Netzeinspeiseüberwachung ist dann nicht mehr zuverlässig möglich. Daher soll ein Neutralleiterbruch am Messgeräteeingang erkannt werden können. Dazu wird das Messgerät mit einer erfindungsgemäßen Vorrichtung zum Erkennen eines Neutralleiterbruches versehen. Die erfindungsgemäße Vorrichtung verhindert falsche Messungen aufgrund eines gebrochenen Neutralleiters.

Das Gerät 100 mit den Messfunktionen zur Netzeinspeiseüberwachung hat erfindungsgemäß auch die Funktion des sicheren Erkennens eines Neutralleiterbruches in der Zuleitung zu dem Gerät.

Wenn eine Unterbrechung des Neutralleiters erkannt wird, kann der in der erfindungsgemäßen Anordnung vorgesehene Schaltmechanismus den Wechselrichter der Photovoltaikanlage vom Einspeisenetz trennen, um zu verhindern, dass wegen einer fehlerhaften Messung die Qualität der eingespeisten Spannung nicht mehr richtig überwacht werden kann und um somit die Gefahr des Einspeisens von "unsauberer" Spannung zu unterbinden.

Dazu werden in der Anordnung an den Eingang des Gerätes 100 die Phasenleiter L1, L2, L3 und der Neutralleiter N des Drehstromnetzes 1, beispielsweise am Ausgang des Wechselrichters der Photovoltaikanlage, angeschlossen. Wenn eine Unterbrechung des Neutralleiters N am Zugang zu dem Gerät 100 erkannt wird , trennt der in der Anordnung nach Figur 2 vorgesehene Schaltmechanismus 15, hier also das Relais, den Wechselrichter der Photovoltaikanlage vom Einspeisenetz. Dadurch wird verhindert, dass von dem Wechselrichter her am Einspeisepunkt eine nicht korrekt überwachte Spannung in das Einspeisenetz eingebracht wird.

### Bezugszeichenliste

- 100: Gerät
- N: Neutralleiter
- L1: Phase
- L2: Phase
- L3: Phase
- 1: Drehstromnetz
- 2: virtueller Nullpunkt
- 3: Widerstand
- 4: Widerstand
- 5: Widerstand
- 6: Widerstand
- 7: Widerstand
- 8: Widerstand
- 9: Widerstand
- 10: Widerstand
- 11: Abbildungsschaltung
- 12: Messvorrichtung
- 12b: Funktionsblock Phasenmessung
- 12a: Funktionsblock Neutralleitersignal
- 13: Gleichanteil-Erkennungsvorrichtung
- 14: Steuersignal
- 16: Diode
- 17: Diode
- 18: Diode
- 19: Widerstand
- 20: Verbindungspunkt
- 21: Spannungssignal zwischen L1 und N
- 22: Spannungssignal zwischen L2 und N
- 23: Spannungssignal zwischen L3 und N
- 24: internes Neutralleitersignal bei ungestörtem Neutralleiter
- 25: Spannungssignal zwischen L1 und L2
- 26: Spannungssignal zwischen L2 und L3
- 27: Spannungssignal zwischen L1 und L3
- 28: internes Neutralleitersignal bei unterbrochenem äußeren Neutralleiter

## Patentansprüche

1. Vorrichtung zum Erkennen eines Neutralleiterbruches in der Zuleitung zu einem an einem Drehstromnetz (1) mit Phasenleitern (L1,L2,L3) und einem Neutralleiter (N) betriebenen Gerät (100), **dadurch gekennzeichnet, dass** in der Vorrichtung ein virtueller Sternpunkt (2) durch Zusammenschalten der Phasenleiter (L1,L2,L3) und des Neutralleiters (N) über Spannungsteiler (3, 4; 5, 6; 7, 8; 9, 10) mit jeweiligem Mittelabgriff gebildet ist, dass die Vorrichtung eine Messvorrichtung (12) mit einem Messeingang hat zur Erfassung wenigstens des Messsignalverlaufs des Neutralleiters (N) am Mittelabgriff des dem Neutralleiter (N) zugeordneten Spannungsteilers (9, 10), dass die Vorrichtung eine resistive und gleichrichtende Eigenschaften aufweisende Abbildungsschaltung (11) hat, die in der Vorrichtung zwischen die drei Phasen (L1, L2, L3) und den Neutralleiter (N) geschaltet ist, wodurch bei Unterbrechung des Neutralleiters (N) das Messsignal des Neutralleiters bezogen auf den virtuellen Sternpunkt mit einem Gleichanteil beaufschlagt wird.

2. Vorrichtung nach Anspruch 1, **dadurch gekennzeichnet, dass** die Abbildungsschaltung (11) bei Unterbrechung des Neutralleiters (N) die Einhüllende von einer, zwei oder der drei Phasen (L1, L2, L3) auf den Messeingang des Neutralleiters (N) abbildet.

3. Vorrichtung nach Anspruch 1, **dadurch gekennzeichnet, dass** die Spannungsteiler (3, 4; 5, 6; 7, 8; 9,10) identische Spannungsteiler (3, 4; 5, 6; 7, 8; 9,10) sind.

4. Vorrichtung nach einem der Ansprüche 1 bis 3, **dadurch gekennzeichnet, dass** die Abbildungsschaltung (11) ein gleichrichtendes Element (16, 17, 18) umfasst, wobei der Eingang des gleichrichtenden Elementes (16, 17, 18) mit der dem Element zugeordneten Phasenleitung (L1, L2, L3) verbunden ist, und dass die Abbildungsschaltung (11) ein resistives Element (19) umfasst, das den Ausgang des gleichrichtenden Elementes (16, 17, 18) mit dem Eingang des dem Neutralleiter zugeordneten Spannungsteilers (9,10) verbindet.

5. Vorrichtung nach Anspruch 4, **dadurch gekennzeichnet, dass** die Abbildungsschaltung (11) für jede Phase (L1, L2, L3) ein gleichrichtendes Element (16, 17, 18) umfasst, wobei der Eingang jedes gleichrichtenden Elementes (16, 17, 18) mit der diesem Element zugeordneten Phasenleitung (L1, L2, L3) verbunden ist, wobei die Ausgänge der gleichrichtenden Elemente (16, 17, 18) in einem Verbindungspunkt (20) zusammengeschaltet sind, und dass die Abbildungsschaltung (11) ein resistives Element (19) umfasst, das den Verbindungspunkt (20) der gleichrichtenden Elemente (16, 17, 18) mit dem Eingang des dem Neutralleiter zugeordneten Spannungsteilers (9,10) verbindet.

6. Vorrichtung nach Anspruch 1, **dadurch gekennzeichnet, dass** die Vorrichtung eine Gleichanteil-Erkennungsvorrichtung (13) für das von der Messvorrichtung (12a) am Messeingang erfasste Messsignal des Neutralleiters (N) hat, die bei Erkennen eines Gleichanteils des Messsignals des Neutralleiters (N) ein Steuersignal (14) erzeugt, wobei das Steuersignal (14) ein Fehlen oder eine Unterbrechung des Neutralleiters (N) anzeigt.

7. Vorrichtung nach Anspruch 1, **dadurch gekennzeichnet, dass** die Messvorrichtung (12) einen Mikrocontroller umfasst, der die Messsignal-Erfassung und Messsignal-Verarbeitung durchführt, wobei die Stromversorgung des Mikrocontrollers galvanisch getrennt ist von dem Drehstrom-Netz (1).

8. Vorrichtung nach Anspruch 1, **dadurch gekennzeichnet, dass** die Messvorrichtung (12) eine analoge elektronische Integrator-Schaltung umfasst zur Erkennung eines Gleichanteils im Mittelwert des Messsignals des Neutralleiters (N).

9. Vorrichtung nach Anspruch 1, **dadurch gekennzeichnet, dass** jeder Spannungsteiler einen ersten, hohen Spannungsteiler-Widerstand (3, 5, 7, 9) hat zur Begrenzung des Stroms, der in die Messvorrichtung (12) fließt, und einen zweiten, niedrigen Spannungsteiler-Widerstand (4, 6, 8, 10) zur Anpassung der Netzspannung an das erlaubte Eingangsspannungs-Niveau der Messvorrichtung (12).

10. Verfahren zum Erkennen eines Neutralleiterbruches in der Zuleitung zu einem an einem Drehstromnetz (1) mit Phasenleitern (L1,L2,L3) und einem Neutralleiter (N) betriebenen Gerät (100), mit einer Vorrichtung gemäß einem der vorigen Ansprüche, **gekennzeichnet durch** die Schritte
- Bilden eines virtuellen Sternpunkts (2) **durch** Zusammenschalten der Phasenleiter (L1,L2,L3) und des Neutralleiters (N) über Spannungsteiler (3, 4; 5, 6; 7, 8; 9, 10) mit jeweiligem Mittelabgriff,
- Erfassen des Messsignalverlaufs des Neutralleiters (N) am Mittelabgriff des dem Neutralleiter (N) zugeordneten Spannungsteilers (9, 10),
- Erkennen eines Gleichanteils im Mittelwert des Messsignals des Neutralleiters (N),
- Erzeugen eines Steuersignals (14) bei Erkennen eines Gleichanteils des Messsignals des Neutralleiters (N), wobei das Steuersignal (14) ein Fehlen oder eine Unterbrechung des Neutralleiters (N) anzeigt.

11. Anordnung zum Erkennen eines Neutralleiterbruches in der Zuleitung zu einem an einem Drehstromnetz (1) mit Phasenleitern (L1,L2,L3) und einem Neutralleiter (N) betriebenen Gerät (100), **dadurch gekennzeichnet, dass** die Anordnung umfasst
- eine Vorrichtung nach einem der Ansprüche 1 bis 9,
- einen Schaltmechanismus (15) zum Unterbrechen der Phasenleiter (L1,L2, L3), wobei das Steuersignal (14) den Schaltmechanismus (15) derart steuert, dass die Phasenleiter (L1, L2, L3) unterbrochen werden, wenn ein Gleichanteil im Messsignal des Neutralleiters (N) erkannt worden ist.

## Claims

1. Apparatus for identifying a neutral line break in the feed line to an appliance (100) operated at a three-phase system (1) having phase conductors (L1, L2, L3) and a neutral conductor (N), **characterized in that** a virtual star point (2) is formed in the apparatus through interconnection of the phase conductors (L1, L2, L3) and the neutral conductor (N) to a respective centre tap by means of voltage dividers (3, 4; 5, 6; 7, 8; 9, 10), **in that** the apparatus has a measuring apparatus (12) having a measuring input for detecting at least the measurement signal profile of the neutral conductor (N) at the centre tap of the voltage divider (9, 10) associated with the neutral conductor (N), **in that** the apparatus has a mapping circuit (11) having resistive and rectifying properties, said mapping circuit being connected in the apparatus between the three phases (L1, L2, L3) and the neutral conductor (N), wherein, when the neutral conductor (N) is interrupted, the measurement signal of the neutral conductor is supplied with a DC component based on the virtual star point.

2. Apparatus according to Claim 1, **characterized in that**, when the neutral conductor (N) is interrupted, the mapping circuit (11) maps the envelope of one, two or the three phases (L1, L2, L3) onto the measurement input of the neutral conductor (N).

3. Apparatus according to Claim 1, **characterized in that** the voltage dividers (3, 4; 5, 6; 7, 8; 9, 10) are identical voltage dividers (3, 4; 5, 6; 7, 8; 9, 10).

4. Apparatus according to one of Claims 1 to 3, **characterized in that** the mapping circuit (11) comprises a rectifying element (16, 17, 18), wherein the input of the rectifying element (16, 17, 18) is connected to the phase line (L1, L2, L3) associated with the element, and **in that** the mapping circuit (11) comprises a resistive element (19), which connects the output of the rectifying element (16, 17, 18) to the input of the voltage divider (9, 10) associated with the neutral conductor.

5. Apparatus according to Claim 4, **characterized in that** the mapping circuit (11) comprises a rectifying element (16, 17, 18) for each phase (L1, L2, L3), wherein the input of each rectifying element (16, 17, 18) is connected to the phase line (L1, L2, L3) associated with said element, wherein the outputs of the rectifying elements (16, 17, 18) are interconnected in a connecting point (20), and **in that** the mapping circuit (11) comprises a resistive element (19), which connects the connecting point (20) of the rectifying elements (16, 17, 18) to the input of the voltage divider (9, 10) associated with the neutral conductor.

6. Apparatus according to Claim 1, **characterized in that** the apparatus has a DC-component identification apparatus (13) for the measurement signal of the neutral conductor (N) detected at the measurement input by the measuring apparatus (12a), said DC-component identification apparatus generating a control signal (14) when a DC component of the measurement signal of the neutral conductor (N) is identified, wherein the control signal (14) indicates an absence of or an interruption in the neutral conductor (N).

7. Apparatus according to Claim 1, **characterized in that** the measuring apparatus (12) comprises a microcontroller, which performs the measurement signal detection and measurement signal processing, wherein the power supply system of the microcontroller is DC-isolated from the three-phase system (1).

8. Apparatus according to Claim 1, **characterized in that** the measuring apparatus (12) comprises an analogue electronic integrator circuit for identifying a DC component in the average value of the measurement signal of the neutral conductor (N).

9. Apparatus according to Claim 1, **characterized in that** each voltage divider has a first, high voltage-divider resistance (3, 5, 7, 9) for limiting the current flowing in the measuring apparatus (12) and a second, low voltage-divider resistance (4, 6, 8, 10) for adjusting the system voltage to the permitted input voltage level of the measuring apparatus (12).

10. Method for identifying a neutral line break in the feed line to an appliance (100) operated at a three-phase system (1) having phase conductors (L1, L2, L3) and a neutral conductor (N), having an apparatus according to one of the preceding claims, **characterized by** the following steps
- formation of a virtual star point (2) through interconnection of the phase conductors (L1, L2, L3) and the neutral conductor (N) to a respective centre tap by means of voltage dividers (3, 4; 5, 6; 7, 8; 9, 10),
- detection of the measurement signal profile of the neutral conductor (N) at the centre tap of the voltage divider (9, 10) associated with the neutral conductor (N),
- identification of a DC component in the average value of the measurement signal of the neutral conductor (N),
- generation of a control signal (14) when a DC component of the measurement signal of the neutral conductor (N) is identified, wherein the control signal (14) indicates an absence of or an interruption in the neutral conductor (N).

11. Arrangement for identifying a neutral line break in the feed line to an appliance (100) operated at a three-phase system (1) having phase conductors (L1, L2, L3) and a neutral conductor (N), **characterized in that** the arrangement comprises
- an apparatus according to one of Claims 1 to 9,
- a switching mechanism (15) for interrupting the phase conductors (L1, L2, L3),
wherein the control signal (14) controls the switching mechanism (15) in such a way that the phase conductors (L1, L2, L3) are interrupted when a DC component has been identified in the measurement signal of the neutral conductor (N).

## Revendications

1. Dispositif de reconnaissance de la coupure d'un conducteur neutre dans la ligne d'alimentation d'un appareil (100) mis en fonctionnement sur un réseau triphasé (1) comportant des conducteurs de phase (L1, L2, L3) et un conducteur neutre (N), **caractérisé en ce qu'**un point neutre virtuel (2) est formé dans le dispositif en interconnectant les conducteurs de phase (L1, L2, L3) et le conducteur neutre (N) à une prise centrale respective par l'intermédiaire de diviseurs de tension (3, 4 ; 5, 6 ; 7, 8 ; 9, 10), **en ce que** le dispositif comporte un dispositif de mesure (12) muni d'une entrée de mesure destinée à détecter au moins la courbe de variation du signal de mesure du conducteur neutre (N) au niveau de la prise centrale du diviseur de tension (9, 10) associé au conducteur neutre (N), **en ce que** le dispositif comporte un circuit de formation d'images (11) présentant des propriétés résistives et de redressement, lequel circuit de formation d'images est connecté dans le dispositif entre les trois phases (L1, L2, L3) et le conducteur neutre (N), de sorte que le signal de mesure du conducteur neutre est soumis à une composante continue par rapport au point neutre virtuel en cas de coupure du conducteur neutre (N).

2. Dispositif selon la revendication 1, **caractérisé en ce que** le circuit de formation d'images (11) forme l'image de l'enveloppe de l'une, de deux ou des trois phases (L1, L2, L3) à l'entrée de mesure du conducteur neutre (N) en cas de coupure du conducteur neutre (N).

3. Dispositif selon la revendication 1, **caractérisé en ce que** les diviseurs de tension (3, 4 ; 5, 6 ; 7, 8 ; 9, 10) sont des diviseurs de tension identiques (3, 4 ; 5, 6 ; 7, 8 ; 9, 10).

4. Dispositif selon l'une quelconque des revendications 1 à 3, **caractérisé en ce que** le circuit de formation d'images (11) comprend un élément de redressement (16, 17, 18), dans lequel l'entrée de l'élément de redressement (16, 17, 18) est reliée au conducteur de phase (L1, L2, L3) associé audit élément, et **en ce que** le circuit de formation d'images (11) comprend un élément résistif (19) reliant la sortie de l'élément de redressement (16,17,18) à l'entrée du diviseur de tension (9,10) associé au conducteur neutre.

5. Dispositif selon la revendication 4, **caractérisé en ce que** le circuit de formation d'images (11) comprend pour chaque phase (L1, L2, L3) un élément de redressement (16, 17, 18), dans lequel l'entrée de chaque élément de redressement (16, 17, 18) est reliée au conducteur de phase (L1, L2, L3) associé audit élément, dans lequel les sorties des éléments de redressement (16, 17, 18) sont interconnectées en un point de liaison (20), et **en ce que** le circuit de formation d'images (11) comprend un élément résistif (19) reliant le point de liaison (20) des éléments de redressement (16, 17, 18) à l'entrée du diviseur de tension (9, 10) associé au conducteur neutre.

6. Dispositif selon la revendication 1, **caractérisé en ce que** le dispositif comporte un dispositif de détection de composante continue (13) pour le signal de mesure du conducteur neutre (N) détecté par le dispositif de mesure (12a) à l'entrée de mesure, qui génère un signal de commande (14) lorsqu'une composante continue du signal de mesure du conducteur neutre (N) est détectée, dans lequel le signal de commande (14) indique une absence ou une coupure du conducteur neutre (N).

7. Dispositif selon la revendication 1, **caractérisé en ce que** le dispositif de mesure (12) comprend un microcontrôleur qui effectue l'acquisition du signal de mesure et le traitement du signal de mesure, dans lequel l'alimentation électrique du microcontrôleur est isolée de manière galvanique du réseau triphasé (1).

8. Dispositif selon la revendication 1, **caractérisé en ce que** le dispositif de mesure (12) comprend un circuit intégrateur électronique analogique destiné à détecter une composante continue dans la valeur moyenne du signal de mesure du conducteur neutre (N) .

9. Dispositif selon la revendication 1, **caractérisé en ce que** chaque diviseur de tension comporte une première résistance de séparation à haute tension (3, 5, 7, 9) destinée à limiter le courant passant dans le dispositif de mesure (12) et une seconde résistance de séparation à basse tension (4, 6, 8, 10) destinée à adapter la tension du réseau au niveau de tension d'entrée admissible du dispositif de mesure (12).

10. Procédé de détection de la coupure d'un conducteur neutre dans la ligne d'alimentation d'un appareil (100) mis en fonctionnement sur un réseau triphasé (1) comportant des conducteurs de phase (L1, L2, L3) et un conducteur neutre (N), comportant un dispositif selon l'une quelconque des revendications précédentes, **caractérisé par** les étapes consistant à
- former un point neutre virtuel (2) en interconnectant les conducteurs de phase (L1, L2, L3) et le conducteur neutre (N) à une prise centrale par l'intermédiaire de diviseurs de tension (3, 4 ; 5, 6 ; 7, 8 ; 9, 10),
- détecter la courbe de variation du signal de mesure du conducteur neutre (N) au niveau de la prise centrale du diviseur de tension (9, 10) associé au conducteur neutre (N),
- détecter une composante continue dans la valeur moyenne du signal de mesure du conducteur neutre (N),
- générer un signal de commande (14) lors de la détection d'une composante continue du signal de mesure du conducteur neutre (N), dans lequel le signal de commande (14) indique une absence ou une coupure du conducteur neutre (N).

11. Dispositif destiné à détecter la coupure d'un conducteur neutre dans la ligne d'alimentation d'un appareil (100) mis en fonctionnement sur un réseau triphasé (1) comportant des conducteurs de phase (L1, L2, L3) et un conducteur neutre (N), **caractérisé en ce que** le dispositif comprend
- un dispositif selon l'une quelconque des revendications 1 à 9,
- un mécanisme de commutation (15) destiné à couper les conducteurs de phase (L1, L2, L3), dans lequel le signal de commande (14) commande le mécanisme de commutation (15) de manière à ce que les conducteurs de phase (L1, L2, L3) soient coupés lorsqu'une composante continue a été détectée dans le signal de mesure du conducteur neutre (N) .
